(19)

Europäisches
Patentamt
European
Patent Office
Office européen
des brevets

(11) **EP 2 677 348 A2**

(12) **EUROPEAN PATENT APPLICATION**
published in accordance with Art. 153(4) EPC

(43) Date of publication:
**25.12.2013 Bulletin 2013/52**

(21) Application number: **12746640.7**

(22) Date of filing: **16.02.2012**

(51) Int Cl.:
**G02B 1/00** (2006.01)   **H01Q 1/38** (2006.01)
**H01L 31/00** (2006.01)

(86) International application number:
**PCT/KR2012/001174**

(87) International publication number:
**WO 2012/111991 (23.08.2012 Gazette 2012/34)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.02.2011 KR 20110013556
03.01.2012 KR 20120000535**

(71) Applicant: **Korea Advanced Institute Of Science
And Technology
Daejeon 305-701 (KR)**

(72) Inventors:
• **MIN, Bum Ki
Daejeon 305-701 (KR)**

• **LEE, Seung Hoon
Gimhae-si
Gyeongsangnam-do 621-758 (KR)**
• **CHOI, Mu Han
Daejeon 305-340 (KR)**
• **KIM, Yu Shin
Daejeon 305-757 (KR)**

(74) Representative: **Beier, Ralph
V. Bezold & Partner
Patentanwälte
Akademiestraße 7
80799 München (DE)**

(54) **METAMATERIAL HAVING A HIGH REFRACTIVE INDEX**

(57)   The present invention provides a metamaterial having a high refractive index that cannot be found in natural materials. The high-refractive-index metamaterial includes a dielectric substrate and a conductive layer formed on the dielectric substrate. The conductive layer includes a plurality of unit grids defining a specified gap therebetween. The metamaterial has a refractive index equal to or larger than the refractive index of the substrate in a predetermined frequency range.

Fig. 1

EP 2 677 348 A2

**Description**

Field of the Invention

The present invention relates to a metamaterial and, more particularly, to a metamaterial having a high refractive index that cannot be found in natural materials.

Background of the Invention

Transparent materials existing in nature have a low refractive index, except for some semiconductors and nonconductors such lead sulfide (PbS) and strontium titanate ($SrTiO_3$) having a refractive index with a significantly high peak value of 20 or more in a near infrared region (particularly, near a resonance frequency).

In the past several years, there have been developed negative-refractive-index metamaterials given a negative refractive index by allowing the effective dielectric constant and the effective permeability thereof to have negative values in different wavelength regions from a microwave region to a visible light region. However, researches on metamaterials having a positive refractive index opposite to the negative refractive index have less extensively conducted while recognizing the theoretical feasibility thereof. Among the studies conducted earlier, an approach utilizing electric resonances generated in split ring resonators shows an increase in refractive index. However, such designs intrinsically have a high refractive index in a narrow frequency band. The metamaterial exhibits a strong dispersion property in the vicinity of a resonance frequency and maintains a desired refractive index only in a narrow frequency domain. There has been proposed a metamaterial formed of the arrangement of capacitors of sub-wavelength and configured to have a high dielectric constant over a broad band. This metamaterial is still problematic because of its strong diamagnetic effect tending to reduce the magnetic permeability value. In recent years, there is theoretically proposed a broad-band high-refractive-index metamaterial capable of lowering the diamagnetic effect. However, the proposed metamaterial is not easily realizable due to the three-dimensional structure thereof.

Summary of the Invention

Technical Problems

In view of the problems noted above, it is an object of the present invention to provide a high-refractive-index metamaterial in which the degree of polarization and magnetization is intentionally controlled.

Means for Solving the Problems

In accordance with the present invention, there is provided a high-refractive-index metamaterial, including: a dielectric substrate; and a conductive layer formed on the dielectric substrate, the conductive layer including a plurality of unit grids defining a specified gap therebetween, wherein the metamaterial has a refractive index equal to or larger than the refractive index of the substrate in a predetermined frequency range.

In the metamaterial according to the present invention, the refractive index of the metamaterial may be equal to or larger than 35 in the predetermined frequency range. The refractive index of the metamaterial may be at least ten times greater than the refractive index of the substrate.

In the metamaterial according to the present invention, the thickness of the conductive layer may be equal to or smaller than a skin depth in the predetermined frequency range.

In the metamaterial according to the present invention, the gap width may be adjusted to ensure that the unit grids are strongly coupled to one another. The gap width may be smaller than the thickness of the conductive layer. The gap width may be adjusted to ensure that the unit grids fall within a parallel plate capacitor regime.

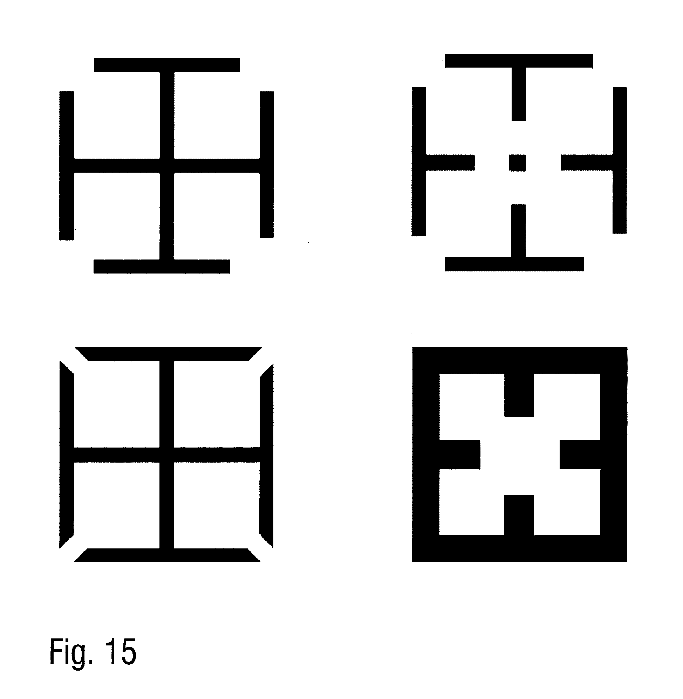

In the metamaterial according to the present invention, each of the unit grids may have an I-like shape, a rectangular shape or a hexagonal shape. Each of the unit grids may have a rotation symmetry structure. Each of the unit grids may have a shape shown in Fig. 15.

In the metamaterial according to the present invention, the dielectric substrate on which the conductive layer is formed is stacked in multiple layers.

Advantageous Effects of the Invention

The high-refractive-index metamaterial according to the present invention has an unnaturally high refractive index because the degree of polarization and magnetization thereof is intentionally controlled. Use of a substrate made of a pliable material makes it possible to cover a three-dimensional material with the metamaterial. Thus, the metamaterial can find its application in many different fields.

The high-refractive-index metamaterial has a high refractive index unavailable in the prior art. Therefore, the metamaterial can be applied to not only a general metamaterial field but also a modified optic field which is recently spotlighted for the arbitrary control of an electromagnetic wave path. In particular, the high-refractive-index metamaterial may become a start point of the study on a transparent cape technology, a super-wide-angle metamaterial lens, a high-density resonator, an ultra-small optical element and so forth.

The high-refractive-index metamaterial may be extensively applied to a lower frequency band such as a microwave, a radio wave, a near infrared ray or a visible ray. Moreover, the high-refractive-index metamaterial is promised to play a great role in developing an imaging system capable of distinguishing an ultra-small object having a size less than a wavelength.

Brief Description of the Drawings

Fig. 1 is a perspective view a high-refractive-index metamaterial according to one embodiment of the present invention.
Fig. 2 is a perspective view showing a basic component unit of the high-refractive-index metamaterial shown in Fig. 1.
Fig. 3 is a photograph illustrating a metamaterial produced.
Fig. 4 is a view showing the calculation result of an electric field distribution around a single-layer metamaterial at a frequency of 0.33 THz.
Fig. 5 is a view showing the calculation result of a magnetic field distribution around a single-layer metamaterial at a frequency of 0.33 THz.
Fig. 6 is a view showing the effective dielectric constant and the permeability of the high-refractive-index metamaterial.
Fig. 7 is a view showing the refractive index and the FOM value of the high-refractive-index metamaterial.
Fig. 8 is a view showing the effective dielectric constant and the permeability of a multi-layer high-refractive-index metamaterial.
Fig. 9 is a view showing the refractive index and the FOM value of the multi-layer high-refractive-index metamaterial.
Fig. 10 is a view showing the transmission and reflection spectrum and the band structure of the multi-layer high-refractive-index metamaterial.
Fig. 11 is a view showing the changes of the refractive index and the frequency indicated by the maximum value of the refractive index, which depend on the gap width of the high-refractive-index metamaterial.
Fig. 12 is a view showing the change of the refractive index depending on the frequency of the high-refractive-index metamaterial.
Fig. 13 is a view for explaining a production process of the high-refractive-index metamaterial.
Fig. 14 is a view showing the refractive index of a two-dimensionally isotropic high-refractive-index metamaterial.
Fig. 15 is a view showing different modified examples of the basic component unit of the isotropic high-refractive-index metamaterial.

Detailed Description of the Preferred Embodiments

A high-refractive-index metamaterial according to the present invention will now be described in detail with reference to the accompanying drawings. While a terahertz wave region is taken as an example in the following description, the region may be expanded to a lower frequency band such as a microwave, a radio wave, a near infrared ray or a visible ray.

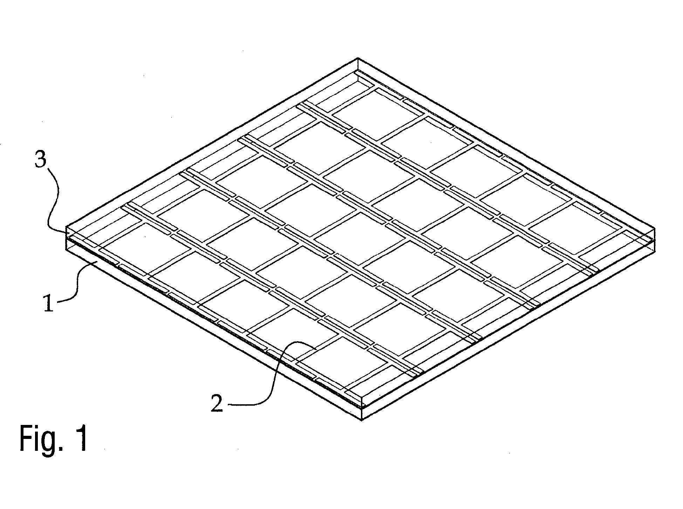

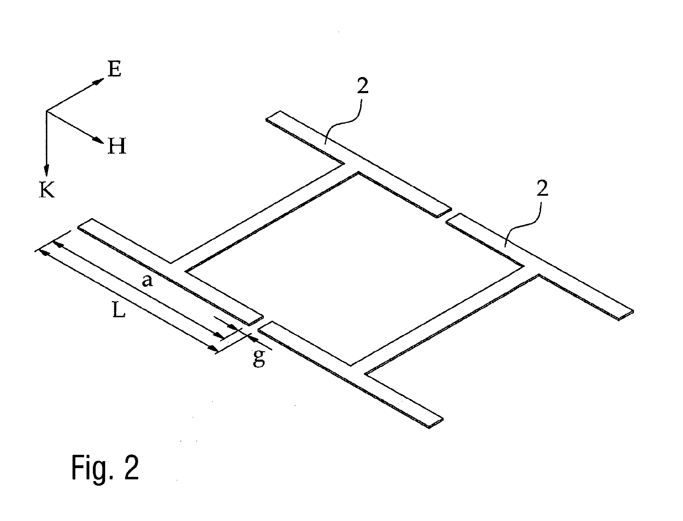

Fig. 1 is a perspective view a high-refractive-index metamaterial according to one embodiment of the present invention. Fig. 2 is a perspective view showing a basic component unit of the high-refractive-index metamaterial shown in Fig. 1. Referring to Figs. 1 and 2, the high-refractive-index metamaterial according to one embodiment of the present invention includes a pair of dielectric substrates 1 and 3 and a conductive layer consisting of a plurality of unit grids 2 arranged between the dielectric substrates 1 and 3.

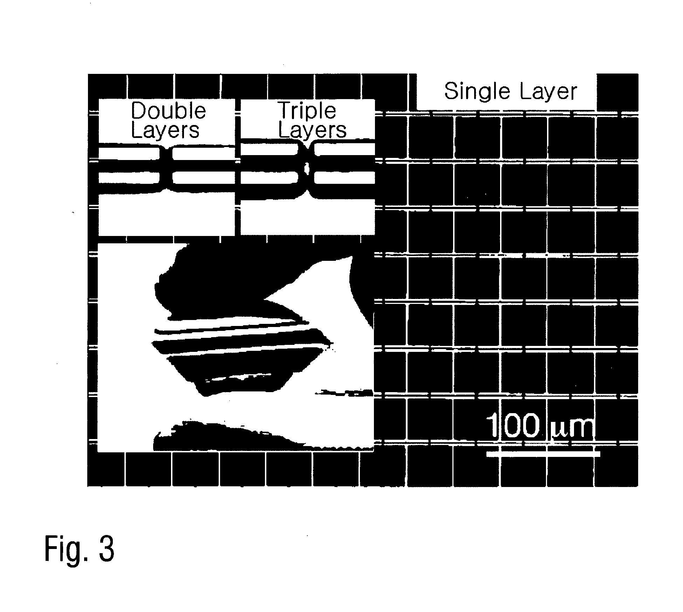

In Fig. 2, k indicates the polarization direction of terahertz wave incident on the unit grids 2. The substrate 1 is made of polyamide (whose refractive index n is equal to 1.8). Gold or aluminum (on a small amount of chromium) is used as the conductive layer. Fig. 3 shows a pliable metamaterial having a large area ($2 \times 2$ cm$^2$). It can be noted from the partially-enlarged microscopic photograph shown in Fig. 3 that the respective layers are precisely arranged in case of multiple layers. Since the substrates are made of polyamide with pliability, the metamaterial produced is quite pliable as can be aware from the enlarged photograph shown in Fig. 3.

The gap width g between basic component units, which is defined by *g=L-a*, plays a very important role in increasing the effective dielectric constant. A thin I-like metal patch structure shows different asymptotic behaviors in a weakly-coupled region and a strongly-coupled region depending on the gap width. In the strongly-coupled region, the opposite electric charges are attracted as the gap width grows smaller. Thus, a myriad of surface electric charges are accumulated in the respective arms of capacitors (referred to as "I-like individual capacitors"). The electric charges gathered in the corners of the capacitors generate enormous dipole moments whose magnitude is inversely proportional to the gap width ($Q^{OC} L^3 g^{-1}$). The massive amount of electric charges thus accumulated generates enormous dipole moments (or large polarization densities), eventually leading to a large effective dielectric constant. On the other hand, in the weakly-coupled region, the amount of electric charges and the decrease of the gap width have the following quadratic function relationship: $Q^{OC} (L-g)^2$.

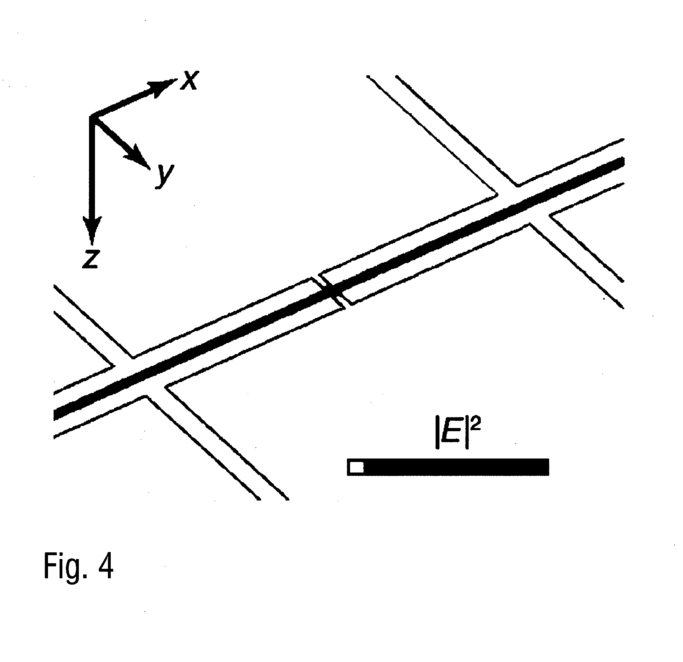

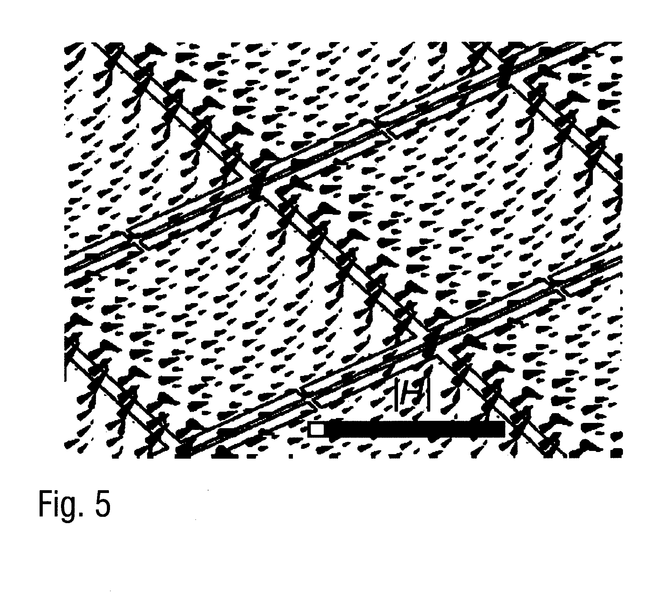

The effective dielectric constant can be increased by reducing the gap width. In order to obtain a large refractive index, however, it is still necessary to reduce the diamagnetic effect. A thin I-like metallic structure is effective in minimizing the area in which a rotating current can be generated, and eventually minimizing the diamagnetism. For the actual realization of such a theoretical argument, the metamaterial should be produced into a thin film having a thickness equal to or smaller than a skin depth (100 nm) in a terahertz wave region. Figs. 4 and 5 show the calculation results of an electric field distribution and a magnetic field distribution around a single-layer metamaterial at a frequency of 0.33 THz. As mentioned earlier, the electric fields are strongly collected in the gaps between unit structures. Since the metal volume is negligibly small, the magnetic fields can deeply penetrate the unit structures.

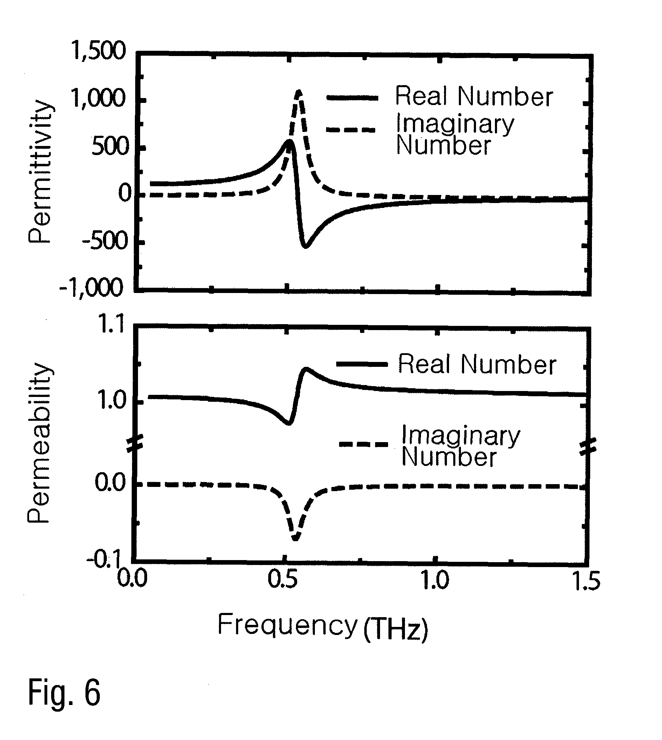

In order to quantify the effect of extremely large dipole moments and weak diamagnetism associated with the proposed metamaterials, an effective parameter retrieving method was used to extract relevant material parameters, such as refractive index n and impedance z (or equivalently, the effective permittivity $\varepsilon_r = n z_0 / z$ and the permeability $\mu_r = n z / z_0$, where $z_0$ is the impedance of free space) from the scattering parameters. As can be confirmed from Fig. 6, a permittivity of 583 is observed at a frequency of 0.504 THz where a strong electric resonance appears, and a permittivity of 122 is observed in a frequency domain where quasi-static fields appear. These values are remarkably higher than the permittivity, 3.24, of polyamide films.

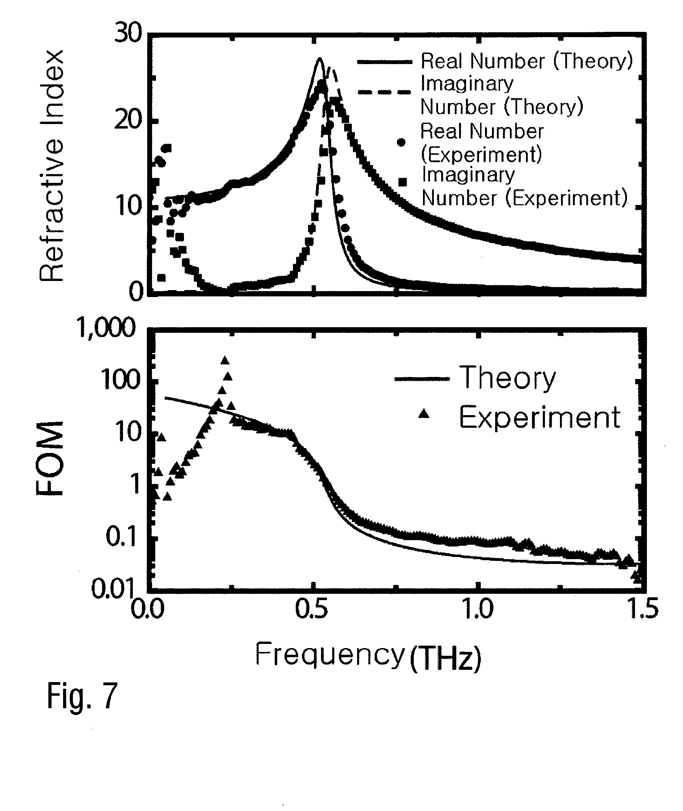

Unlike the permittivity, the magnetic permeability remains substantially equal to 1 over the whole frequency domain, except near the frequency of the electric resonance, where a weak magnetic anti-resonance accompanying the strong electrical resonance is observed. As shown in Fig. 7, by virtue of this extreme enhancement of permittivity along with the minimization of diamagnetism, the refractive index has a maximum value of 27.25 at 0.516 THz and a value of 11.1 in a quasi-static domain. The thickness (52.45 mm) of the metamaterial falls within the effective wavelength range of terahertz waves, which justifies the application of homogenization theory and the effective parameter description. For the consistency in analysis, an effective refractive index is derived using the actual thickness of the metamaterial. However, the actual effective refractive index is lower than the index acquired with the actual thickness of the metamaterial. This is because the effective thickness of a single-layer metamaterial depends on the degree of mode decay.

To experimentally probe the enhancement of the effective refractive index, terahertz time-domain spectroscopy is performed for a frequency range of 0.1- 1.5 THz. All the samples are produced with conventional micro/nano-lithography technologies as discussed below. For reliable extraction of the complex refractive index from the terahertz time-domain experiments, an iterative algorithm is applied to the electric field signal transmitting the samples. Next, the complex refractive indices extracted from the terahertz time-domain measurements are compared with the numerically obtained refractive indices derived by an S-parameter extraction method. Considering the uncertainties in the material parameters used for the simulation and the errors in the gap-width measurements, the experimentally acquired complex refractive index is in excellent agreement with the simulated refractive index as shown in Fig. 7. From the characterization of the single-layer metamaterial, a peak refractive index (n=24.34) at 0.522 THz is observed, with a refractive index of 11.18 at the quasi-static limit. The loss associated with the single-layer metamaterial is quantified by the FOM (Figure of Merit). The FOM is a criterion for finding the energy loss generated when electromagnetic waves pass through the metamaterial, and is defined by Re(n)/Im(n). The loss becomes smaller as the FOM grows higher. The experimental and numerical values of the FOM can be confirmed in Fig. 7. For most frequency ranges, especially in the lower portion below the electric resonance, the FOM stays above 10, with a peak value exceeding 100.

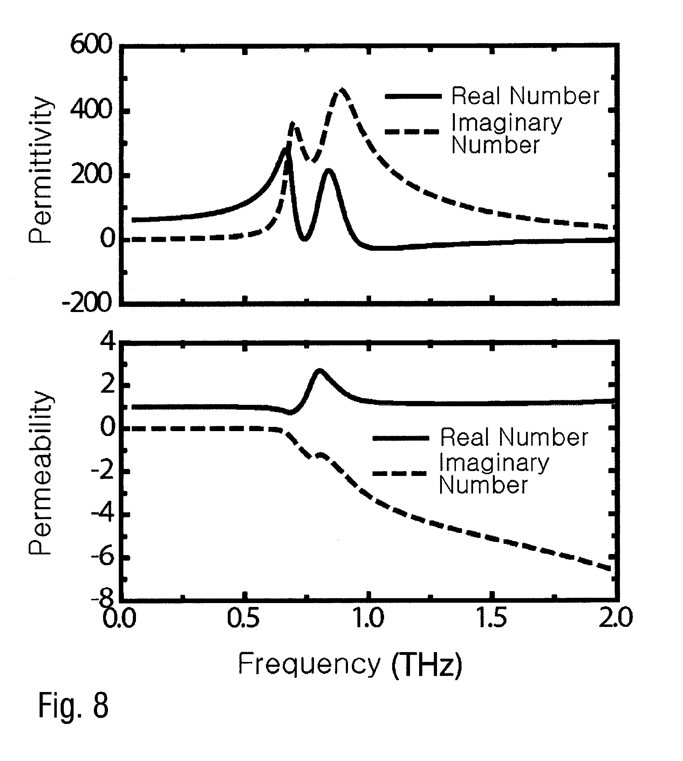

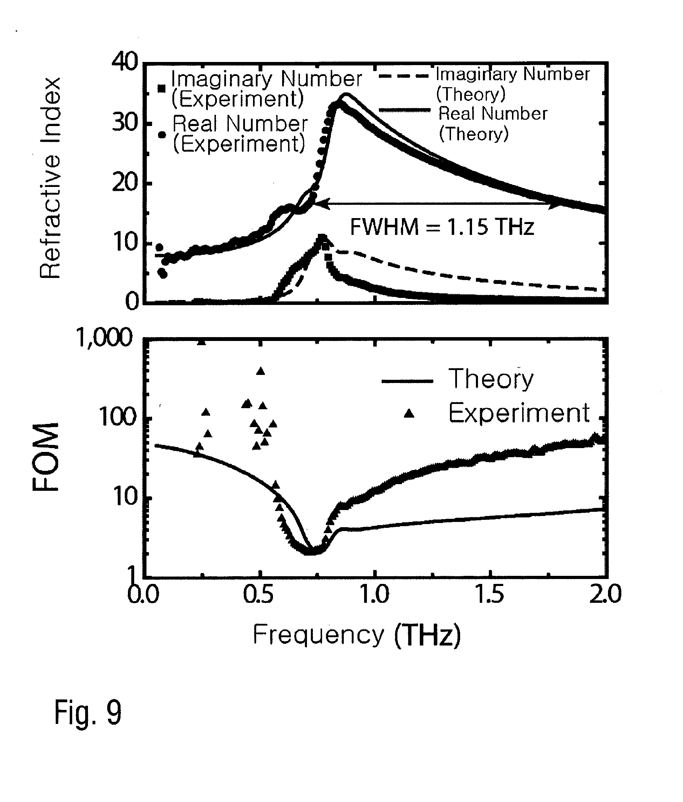

Although the possibility of raising the refractive index has been experimentally demonstrated for single-layer metamaterials, description will now be made on how to acquire three-dimensional high-index metamaterials. In order to investigate the bulk properties (two-dimensional film expanded to three-dimensional films in order to use the concept of a material), quasi-three-dimensional high-index metamaterials containing up to five layers are fabricated and tested. The permittivity, the permeability, the complex refractive index and the FOM calculated or measured in a five-layer high-refractive-index metamaterial having a small interlayer spacing (1.62 $\mu$m) are plotted in Figs. 8 and 9 and are well matched up with the simulation values. From the terahertz time-domain measurements and subsequent parameter extraction, the highest index of refraction of 33.22 is obtained at a frequency of 0.851 THz. Interestingly, the refractive index does not fall sharply at higher frequencies, and shows an extremely broadband high refractive index with a full-width at half-maximum (FWHM) of 1.15 THz. Although all the effective refractive indices are given here for normal incidence, the high-index metamaterials are quite robust to incidence angle variations. This robustness has its origin in the weak dependence of effective permeability on the direction of incident magnetizing field.

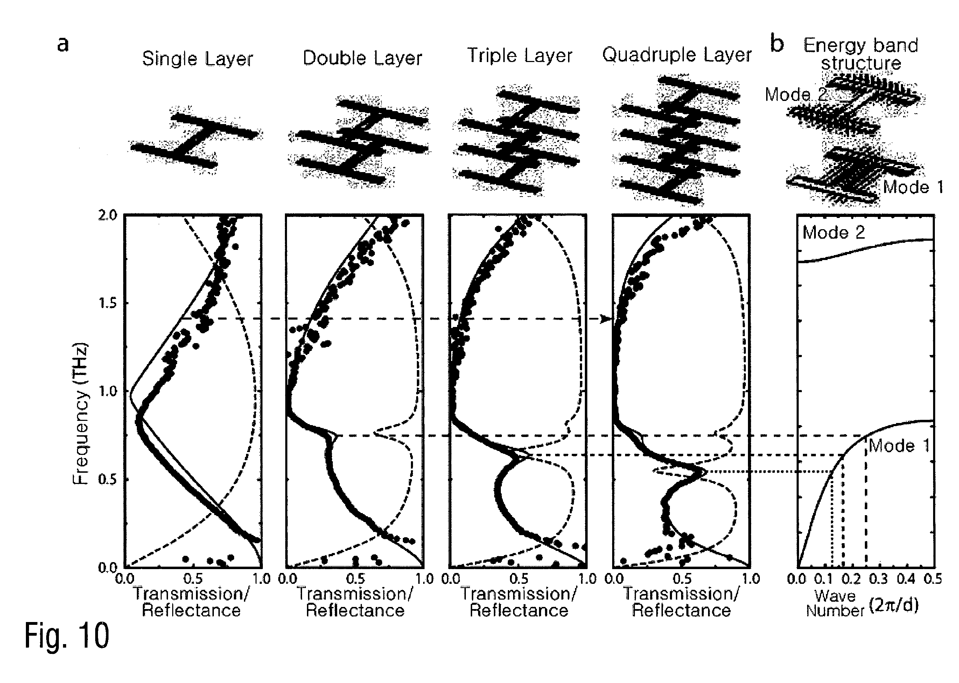

The presence of coupling between layers of quasi-three-dimensional metamaterials leads to substantial differences in the refractive index and the transmission spectra when compared to single-layer metamaterials. To better understand the influence of the number of layers, the band structure is analyzed and the dispersion relation is plotted in Fig. 10. The thickness of the unit cell (d=12.2 μm) is intentionally increased relative to those of the samples designed for a high refractive index so that the interlayer coupling and the changes in the corresponding transmission spectra can be clearly investigated. The band structure is indicative of the limiting case of perfectly periodic metamaterials in the z-direction. In conjunction with the effective parameter description, the band gap between 0.833 and 1.734 THz corresponds to the negative effective permittivity regime. As clearly shown in Fig. 10, the transmission (transmittance) corresponding to these band gap frequencies is gradually lowered as the number of layers is increased, which is indicative of a progressive band gap formation. In addition to this band gap formation, transmission peaks appear in the spectra, which can be interpreted several ways. From a homogeneous slab description, the metamaterial can be treated as a Fabry-Perot etalon. The round trip phase delay should be a non-negative integer multiple of 2n and the transmission of the slab is maximized under the condition $f_p = pc/2nNd$, where $f_p$ denotes the frequency of the transmission peak, p is a non-negative integer and c is the speed of light. From a microscopic point of view, the transmission peaks originate from the Bloch-like modes that are phase-matched to the Fabry-Perot resonance of the metamaterial slab. For example, the single transmission peak observed in the double-layer metamaterial corresponds to the Bloch mode that has a normalized wave number of $1/2 \times \pi/d$. Generalized to the samples with larger numbers of layers, the transmitting modes correspond to the Bloch modes having a wave number of $p/N \times \pi/d$, where p is 0, ⋯, N-1.

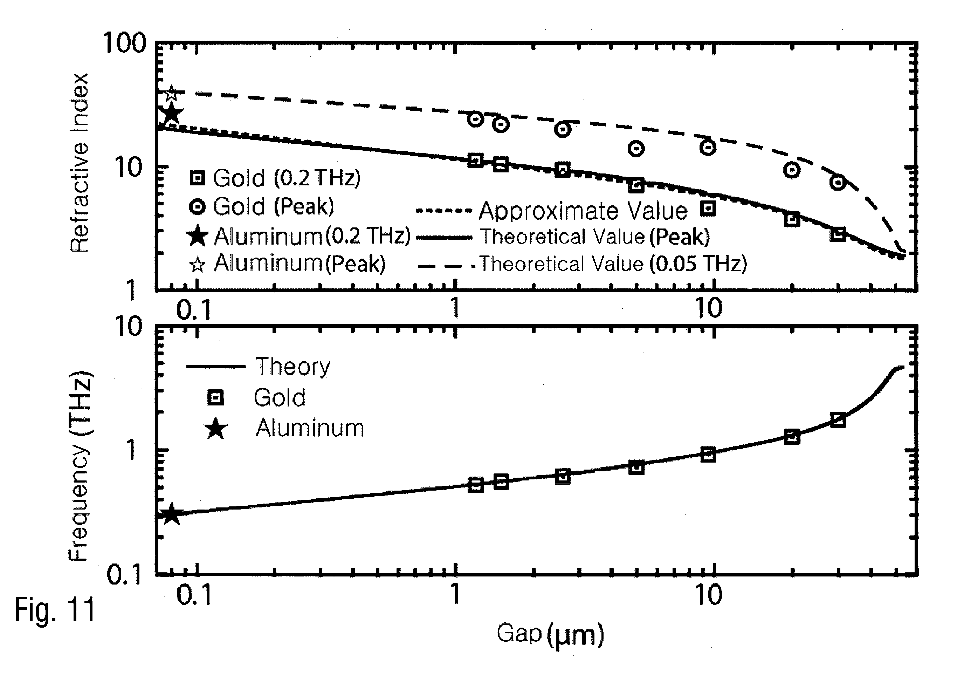

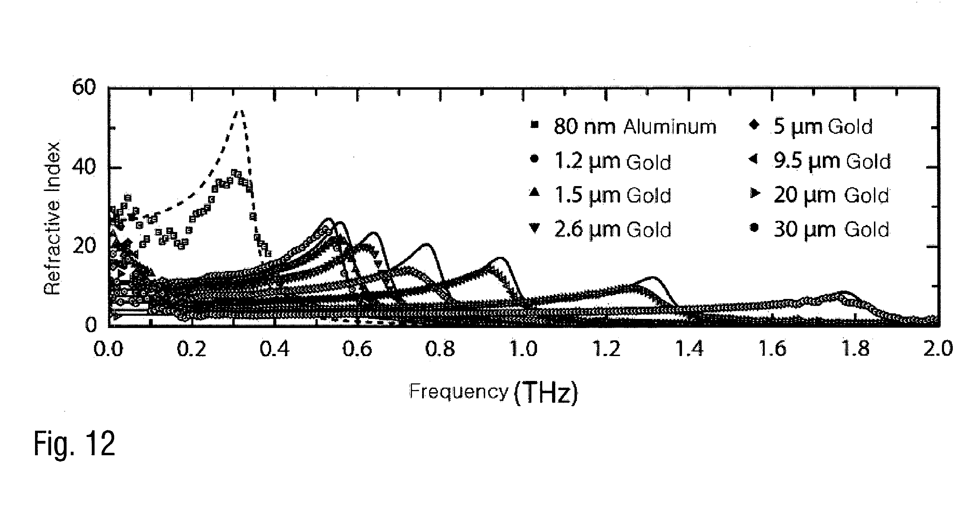

The refractive index of the proposed high-index metamaterials is a sensitive function of the gap width. Bearing this in mind, the question of the positive limit of a physically achievable refractive index naturally arises. To experimentally approach this question, the refractive indices of metamaterials are measured while changing the gap width from 80 nm to 30 μm. Fig. 11 shows the measured and numerically estimated indices of refraction as a function of the gap width (the upper panel in Fig. 11 shows the peak index and the index at the quasi-static limit; and the lower panel in Fig. 11 shows the peak index frequency). Theoretical refractive indices obtained from an empirical asymptotic formula are also plotted for the quasi-static limit. The numerically estimated index is 26.6 at the quasi-static limit and increases to 54.87 at 0.315 THz for the sample with 80 nm gap width (the experimentally measured value is greater than 20 at the quasi-static limit and 38.64 at its peak; see Fig. 12). In the weakly coupled regime, the capacitive coupling between unit cells is negligible so that the refractive index can be approximated as

$$n \approx n_p \left\{ 1 + \frac{\pi \alpha L}{2\sqrt{2d}} \left( 1 - \frac{g}{L} \right)^3 + \frac{\pi \alpha \beta L}{2\sqrt{2}} \left( 1 - \frac{g}{L} \right)^4 \right\}$$

where $\alpha$ and $\beta$ are dimensionless fitting parameters. However, as the gap width decreases, the capacitive effect due to coupling between unit cells becomes dominant. As a result, the index of refraction is drastically increased, with a dominant term proportional to the inverse $(1-\beta)/2$-th power of the gap width (provided that the gap width is larger than the metal thickness). Furthermore, once the gap width becomes smaller than the thickness of the metallic patch, the effective refractive index will increase even faster as the parallel plate capacitor regime is reached. Therefore, it should be possible to achieve an even higher index of refraction by further reducing the gap width or the spacing between the metamaterial layers. As the gap width decreases, this increase is expected to continue until the gap width approaches the Thomas-Fermi length scale or the quantum tunneling scale of electrons. In addition to this gap width control, it is worth noting that the effective refractive index is proportional to the substrate refractive index. Thus, the introduction of a higher-index substrate will lead to greater amplification of the refractive index and an unprecedentedly large effective refractive index.

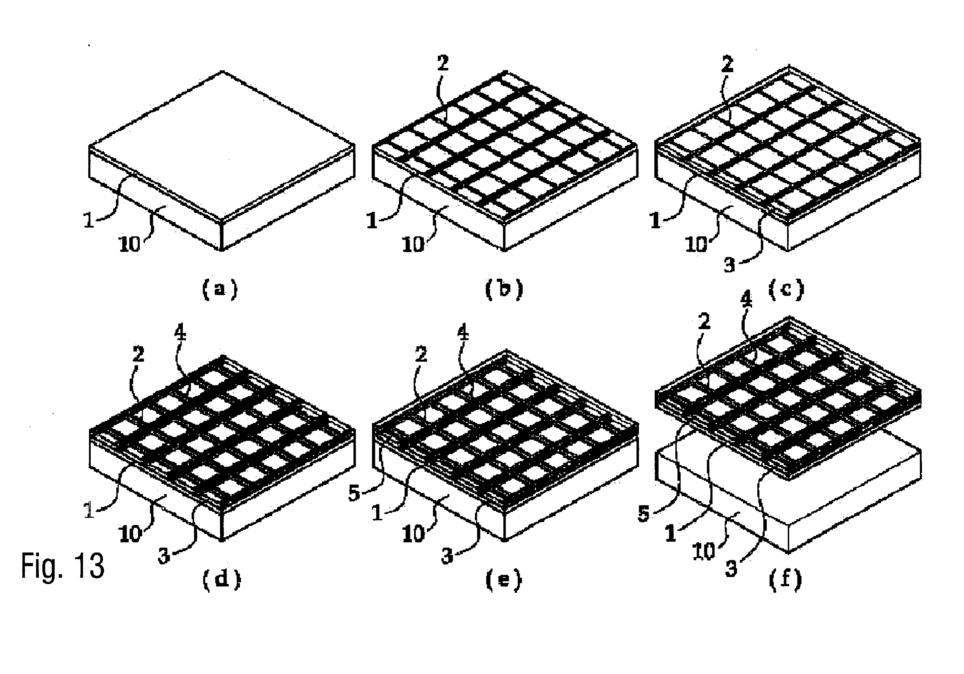

Referring to Fig. 13, description will now be made on a process for producing a metamaterial having a micro gap.

A polyamide solution is spin-coated on a silicon substrate 10 and is then softly baked in a convection oven at 180°C. A curing process (polymer curing process) is performed in a quartz tube furnace at 350°C under an inert gas atmosphere. At this time, as shown in Fig. 13(a), the polyamide solution becomes a hardly-soluble polyamide film 1. A negative photoresist is spin-coated on the polyamide film 1 and a pattern is formed using a photolithography technology. Then, chromium and gold are deposited one after another by an electron beam vapor deposition system. Thereafter, as shown in Fig. 13(b), an I-like pattern 2 is formed in a lift-off process. As shown in Fig. 13(c), a process for forming a polyamide film 3 is performed once again. A pliable polyamide/metal/polyamide structure is detached from a silicon wafer 10 used as a sacrificing layer, thereby producing a pliable metamaterial. If necessary, as shown in Figs. 13(d) and 13(e), a process for forming a metallic layer 4 and a polyamide layer 5 on the polyamide layer 3 is performed once again. Thereafter, as shown in Fig. 13(f), a structure consisting of pliable polyamide layers 1, 3 and 5 and metallic layers 2 and 4 is detached from the silicon wafer 10, consequently producing a multi-layer metamaterial. The structural size of the micro-gap metamaterial is measured by a microscope, a surface measuring instrument and a three-dimensional measuring instrument.

A nano-gap metamaterial is produced in the same method as used in producing the micro-gap metamaterial, except a nano-gap formation step that makes use of electron beam lithography. Aluminum is deposited on a silicon substrate coated with a polyamide solution. In a lift-off step, a pattern consisting of I-like unit cells is formed. A gap of a metamaterial is drawn by large-area electron beam lithography. Then, a gap is formed by etching aluminum with an electron beam resist as an etching mask.

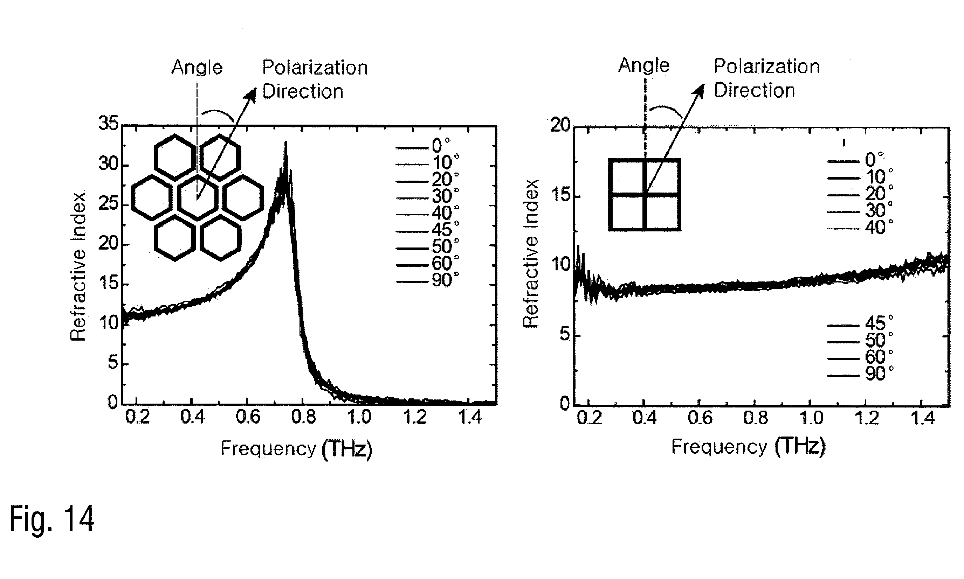

Fig. 14 is a view showing the refractive index of a two-dimensionally isotropic high-refractive-index metamaterial according to another embodiment of the present invention. As shown in Fig. 14, two kinds of structures are fabricated in order to produce a two-dimensionally isotropic high-refractive-index metamaterial. One is a structure having a water clover shape. The other is a structure having a honeycomb shape. The structure capable of obtaining isotrope is not limited to the above structures. A rotation symmetry structure has an isotropic property. As can be aware in Fig. 14, the two structures of rotation symmetry have an isotropic property and show a substantially identical response when polarized light of 0 to 90 degrees is incident thereon. Fig. 15 is a view showing different modified examples of the basic component unit of the isotropic high-refractive-index metamaterial.

A method of controlling the resonance frequency of the metamaterial will be described. Considering only the permittivity and the permeability, it is suitable to use a thin film having a triangular shape, a rectangular shape or a hexagonal shape, or a structure having a triangular ring shape, a rectangular ring shape or a hexagonal ring shape with a penetrated center. If small rings are additionally provided within a structure by adding link rods to the penetrated portion of the rectangular ring structure, for example, if the rectangular ring structure is formed into a water clover shape by adding two rods to the penetrated portion thereof, the induction coefficient (inductance) of the metamaterial undergoes a change, which leads to a change of the resonance frequency of the unit grids. The structure having a small size possesses a smaller induction coefficient. The resonance frequency is inversely proportional to the square root of the induction coefficient. As a consequence, the resonance frequency becomes larger. This makes it possible to control the resonance frequency of the metamaterial.

While certain preferred embodiments of the invention have been described above, the present invention is not limited to these embodiments. It will be apparent to those skilled in the relevant art that various modifications may be made without departing from the scope of the invention defined in the claims. Such modifications shall be construed to fall within the scope of the present invention.

For example, while the unit grids are made of metal in the aforementioned embodiments, all kinds of electrically conductive materials, e.g., graphene can be used as the unit grids.

While the polyamide film is used as the substrate and the unit grids are made of gold, most of dielectric films can be used as the substrate. Likewise, most of metal can be used to form the unit grids of the metamaterial.

In addition to the aforementioned unit grids, other structures having unit grid components (with a triangular, rectangular or hexagonal shape) arranged at a quite narrow spacing can be used in producing the high-refractive-index metamaterial.

**Claims**

1. A high-refractive-index metamaterial, comprising:

   a dielectric substrate; and
   a conductive layer formed on the dielectric substrate, the conductive layer including a plurality of unit grids defining a specified gap therebetween,
   wherein the metamaterial has a refractive index equal to or larger than the refractive index of the substrate in a predetermined frequency range.

2. The metamaterial of claim 1, wherein the refractive index of the metamaterial is equal to or larger than 35 in the predetermined frequency range.

3. The metamaterial of claim 1, wherein the refractive index of the metamaterial is at least ten times greater than the refractive index of the substrate.

4. The metamaterial of claim 1, wherein the thickness of the conductive layer is equal to or smaller than a skin depth in the predetermined frequency range.

5. The metamaterial of claim 1, wherein the gap width is adjusted to ensure that the unit grids are strongly coupled to one another.

6. The metamaterial of claim 1, wherein the gap width is smaller than the thickness of the conductive layer.

7. The metamaterial of claim 1, wherein the gap width is adjusted to ensure that the unit grids fall within a parallel plate capacitor regime.

8. The metamaterial of claim 1, wherein each of the unit grids has an I-like shape.

9. The metamaterial of claim 1, wherein each of the unit grids has a rectangular shape.

10. The metamaterial of claim 1, wherein each of the unit grids has a hexagonal shape.

11. The metamaterial of claim 1, wherein each of the unit grids has a rotation symmetry structure.

12. The metamaterial of claim 1, wherein each of the unit grids has a shape shown in Fig. 15.

13. The metamaterial of claim 1, wherein the dielectric substrate on which the conductive layer is formed is stacked in multiple layers.

Fig. 1

Fig. 2

Fig. 3

Fig. 4

Fig. 5

Fig. 6

Fig. 7

Fig. 8

Fig. 9

Fig. 10

EP 2 677 348 A2

Fig. 11

Fig. 12

Fig. 13

Fig. 14

EP 2 677 348 A2

Fig. 15